# EUROPEAN PATENT APPLICATION

(11) **EP 2 747 121 A1**
(43) Date of publication of application: **25.06.2014**
(21) Application number: 12198963.6
(22) Date of filing: 21.12.2012
(51) Int. Cl.: H01J 37/244, H01J 37/28

(54) **Secondary electron optics & detection device**

(71) Applicant: ICT Integrated Circuit Testing Gesellschaft für Halbleiterprüftechnik mbH, 85551 Heimstetten (DE)
(72) Inventor: Lanio, Stefan, 85435 Erding (DE); Frosien, Jürgen, 85521 Riemerling (DE); Schönecker, Gerald, 81739 München (DE); Winkler, Dieter, 81737 München (DE)
(74) Representative: Zimmermann & Partner

(57) **Abstract**

A secondary charged particle detection system for a charged particle beam device (200) is described. The detection system includes a beam splitter (15) for separating a primary beam (130) and a secondary beam (140) formed upon impact on a specimen (13); a beam bender (440) for deflecting the secondary beam; a focusing lens (301) for focusing the secondary beam; a detection element (220, 222) for detecting the secondary beam particles, and three deflection elements (901, 902, 903), wherein at least a first deflector (901) is provided between the beam bender and the focusing lens, at least a second deflector (902) is provided between the focusing lens and the detection element, at least a third deflector (903) is provided between the beam splitter and the detection element.

## Description

### FIELD

Embodiments of the present invention relate to charged particle beam devices, for example, for inspection system applications, testing system applications, lithography system applications, defect review or critical dimensioning applications or the like. In particular, they relate to secondary beam optics and a detection device. Specifically, embodiments relate to a secondary charged particle detection system for a charged particle beam device and a method of detection of secondary charged particles in a charged particle beam device.

### BACKGROUND

Particle detectors (e.g. electron detectors) are used for charged particle beam systems, e.g. electron microscopes for Electron Beam Inspection (EBI), Defect Review or Critical Dimension measurement, Focused Ion Beam systems etc.

Charged particle beam apparatuses have many functions in a plurality of industrial fields, including, but not limited to, inspection of semiconductor devices during manufacturing, exposure systems for lithography, detecting devices and testing systems. Thus, there is a high demand for structuring and inspecting specimens within the micrometer and nanometer scale.

Micrometer and nanometer scale process control, inspection or structuring is often done with charged particle beams, e.g. electron beams, which are generated and focused in charged particle beam devices, such as scanning electron microscopes or electron beam pattern generators. Charged particle beams offer superior spatial resolution compared to, e.g. photon beams, due to their short wavelengths. Also other types of charged particles, e.g. positive ions, could be detected by the device in a variety of different instruments.

Upon irradiation of a sample by a primary beam of electrons, secondary electrons (SE) are created which carry information about the topography of the sample, its chemical constituents, its electrostatic potential and other information. In the simplest detectors, all of the SE are collected and lead to a sensor, usually a scintillator, a pin diode or the like. An image is created where the gray level is proportional to the number of electrons collected.

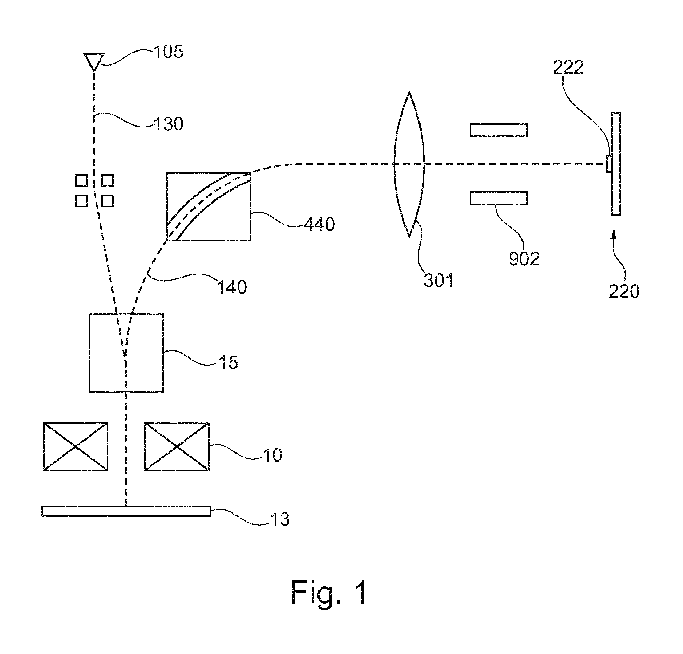

In EBI this kind of Bright Field (BF) detector is also used. However, an increase in sensitivity to changes in topography or surface potential (voltage contrast - VC) is desired. VC can be enhanced by energy filtering the SE signal, while topography information resulting from physical defects can be enhanced by using multiple sensors that collect only SE within certain ranges of take-off angles at the sample. In a EBI system having an SE optics as shown in Fig. 1, this can be done by an optical system consisting of a beam splitter 15 that separates the primary beam 130 and the SE bundle 140, a beam bender 440 that deflects the SE bundle to a large angle (typically 90° for horizontal exit), SE focus lens 301 and an alignment deflector 902 for focusing and aligning the beam to the sensor.

Further, it is desired for many applications that the imaging information is increased while high-speed detection is provided. For example, upon irradiation of a sample by a primary beam of electrons, secondary electrons (SE) are created which carry information about the topography of the sample, its chemical constituents, its electrostatic potential and others. High speed detection provided with topography information and/or information on the energy of the secondary particles is a challenging task, for which continuous improvement is desired. Accordingly, improvements of the detection in the SEM-based tools, particularly in high throughput defect inspection or review tools, are desired. Thereby, enhanced imaging contrast is an important aspect for high throughput metrology and inspection.

Therefore, it is desired to provide means for improved secondary particle optics assuring a high fidelity transfer of the signal particles to the detector.

The object of the present invention is therefore to provide a SE optics and a detection device with improved features while keeping the number of optical elements and the related power supplies as low as possible.

### SUMMARY

In light of the above, a secondary charged particle detection system for a charged particle beam device according to claim 1, a charged particle beam device, including a secondary charged particle detection system according to claim 9 and a method of detection of secondary charged particles in a charged particle beam device according to claim 10 are provided.

According to an embodiment, a secondary charged particle detection system for a charged particle beam device is provided. The detection system includes a beam splitter for separating a primary beam and a secondary beam formed upon impact on a specimen; a beam bender for deflecting the secondary beam; a focusing lens for focusing the secondary beam; a detection element for detecting the secondary beam particles, and three deflection elements, wherein at least a first deflector is provided between the beam bender and the focusing lens, at least a second deflector is provided between the focusing lens and the detection element, at least a third deflector is provided between the beam splitter and the detection element.

According to another embodiment, a method of detection of secondary charged particles in a charged particle beam device is provided. The method includes separating a secondary beam from a primary beam by means of a beam separator; deflecting the separated secondary beam by means of a main deflector; and focusing the secondary beam on a detection element by means of a focusing lens; wherein the secondary beam is deflected by at least a first deflector provided between the beam bender and the focusing lens, at least a second deflector provided between the focusing lens and the detection element, and at least a third deflector provided between the beam splitter and the detection element.

Further advantages, features, aspects and details that can be combined with the above embodiments are evident from the dependent claims, the description and the drawings.

Embodiments are also directed to apparatuses for carrying out the disclosed methods and including apparatus parts for performing each described method step. These method steps may be performed by way of hardware components, a computer programmed by appropriate software, by any combination of the two or in any other manner. Furthermore, embodiments are also directed to methods by which the described apparatus operates. It includes method steps for carrying out every function of the apparatus or manufacturing every part of the apparatus.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Fig. 1 shows schematically a detection system in a charged particle beam device according to the state of the art;
Fig. 2 shows a secondary charged particle detection system for a charged particle beam device according to embodiments described herein;
Fig. 3 shows a secondary charged particle detection system for a charged particle beam device according to embodiments described herein;
Fig. 4 shows a secondary charged particle detection system for a charged particle beam device according to embodiments described herein;
Fig. 5a shows a secondary charged particle detection system for a charged particle beam device according to embodiments described herein;
Fig. 5b shows a secondary charged particle detection system for a charged particle beam device according to embodiments described herein;
Fig. 6 shows a secondary charged particle detection system for a charged particle beam device according to embodiments described herein;
Fig. 7 shows a block diagram of a method of detection of charged particles in a charged particle beam device according to embodiments described herein.

### DESCRIPTION OF THE PREFERRED EMBODIMENTS

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Without limiting the scope of protection of the present application, in the following the charged particle beam device or components thereof will exemplarily be referred to as a charged particle beam device including the detection of secondary electrons or backscattered electrons. As described herein, reference to secondary electrons (SE) can be understood as reference to any secondary and/or backscattered electrons described herein.

Within the following description of the drawings, the same reference numbers refer to the same components. Generally, only the differences with respect to the individual embodiments are described.

A "specimen" as referred to herein, includes, but is not limited to, semiconductor wafers, semiconductor workpieces, and other workpieces such as memory disks and the like. Embodiments of the invention may be applied to any workpiece on which material is deposited or which are structured. A specimen includes a surface to be structured or on which layers are deposited, an edge, and typically a bevel.

According to an embodiment, a secondary charged particle detection system for a charged particle beam device is provided. The detection system includes a beam splitter for separating a primary beam and a secondary beam formed upon impact on a specimen; a beam bender for deflecting the secondary beam; a focusing lens for focusing the secondary beam; a detection element for detecting the secondary beam particles, and three deflection elements, wherein at least a first deflector is provided between the beam bender and the focusing lens, at least a second deflector is provided between the focusing lens and the detection element, at least a third deflector is provided between the beam splitter and the detection element.

According to embodiments described herein, an improved secondary electron optics is provided. Thereby, particular attention is paid to contrast increase during detection of the signals. Improvement of contrast is one of the key factors for faster inspection, i.e. higher throughput during inspection of wafers, specimen or the like. Particularly for electron beam inspection, this is important, because, for example on a 300 mm wafer defects having a size of 40 nm need to be detected, which, thus, have only 5.6*10⁻¹⁶ times the size of the entire area to be scanned.

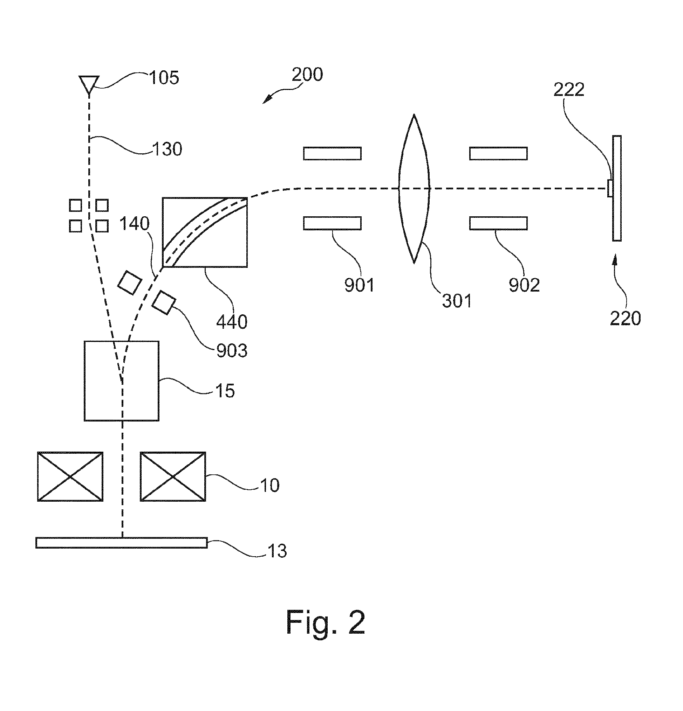

Thereby, as compared to the secondary beam optics shown in figure 1, a plurality of improvements can be provided. The secondary electron optics shown in figure 1 does not provide for energy filtering and detectors, wherein filtering depending upon the starting angle of the secondary electrons can be conducted. The hemispherical beam bender can provide stigmatic focusing for a specific set of operation conditions. Thus, no independent stigmation control can be provided. Yet further, the specific set of operation conditions also limits the flexibility to align the secondary beam, which exits the beam bender, with respect to the secondary electron focusing lens. The scanning of the primary electron beam on the specimen, for example with large field a view, results in movement of the secondary electron beam bundle. Yet further, this movement cannot be compensated for with the specific set of operation conditions for guiding the secondary electron beam. In order to increase the contrast of the secondary electron signals, loss of secondary electrons needs to be reduced and as much information as possible of the information included in the secondary electron beam needs to be conserved for detection thereof. Thereby, in addition, the number of optical elements and the related power supplies should be as low as possible. Fig. 2 shows a charged particle beam device 200, which includes a secondary electron optics according to embodiments described herein. The device includes a charged particle source 105 producing a primary beam 130 which is directed towards a specimen 13 through an objective lens 10. Particles released from or backscattered from the specimen form a secondary beam 140 carrying information about the specimen. Thereby, the information can include information about the topography of the specimen, the chemical constituents, the electrostatic potential, and others. In order to inspect defects as fast as possible, the contrast needs to be increased by using an increased amount of information. Further, Fig. 2 shows a secondary charged particle detection system for a charged particle beam device according to an embodiment. The secondary beam 140 is separated from the primary beam 130 by means of a beam separator 15 and enters a beam bender 440. The beam separator can, for example, include at least one magnetic deflector, a Wien filter, or any other means, wherein the electrons are directed away from the primary beam, e.g. due to the velocity depending Lorenz force.

The beam bender 440 deflects the secondary beam 140 towards a focusing lens 301. The focusing lens 301 focuses secondary beam 140 on a detection element or sensor 222 (scintillator, pin diode etc.) of a detector assembly 220. The detection system according to embodiments illustrated, for example with respect to FIG. 2, allows to focus the secondary particle bundle on a detector for Bright Field (BF) imaging, to adapt the size of the secondary particle bundle, or to adapt the size of the secondary particle bundle to a segmented detector in order to achieve angular resolution as described in more detail below. According to embodiments, three deflectors 903, 901, and 903 are provided along the path of the secondary beam.

According to an embodiment, a secondary charged particle detection system for a charged particle beam device is provided. The detection system includes a beam splitter for separating a primary beam and a secondary beam formed upon impact on a specimen; a beam bender for deflecting the secondary beam; a focusing lens for focusing the secondary beam; a detection element for detecting the secondary beam particles, and three deflection elements, wherein at least a first deflector is provided between the beam bender and the focusing lens, at least a second deflector is provided between the focusing lens and the detection element, at least a third deflector is provided between the beam splitter and the beam bender.

In the embodiment of Fig. 2 a first deflector 901 is arranged between the beam bender 440 and the focusing lens 301, a second deflector 902 is provided between the focusing lens 301 and the detection element 222, and a third deflector 903 is provided between the beam splitter 15 and the beam bender 440. Please note that the third deflector is the first one of the three deflectors through which the SE pass the embodiments described with respect to Fig. 2. This arrangement of the deflectors has the advantage that the deflector, for which the electrons pass first, i.e. the third deflector 903, is provided as soon as possible after separation of the primary beam and the secondary beam. Thereby, counter-scanning or de-scanning can be conducted before the secondary electron beam enters the beam bender 440. Further, the path along which the secondary electrons enter the beam bender 440 can be adjusted. This improves the alignment of the secondary electron beam to the desired optical axis of the secondary electron optics.

When scanning a large Field of View (FOV) with the primary beam, the SE bundle starts moving accordingly and , in general, the SE bundle is scanning across the sensor. For small sensors this may lead to signal loss towards the edges of the FOV. In angular filtering mode it may result in sensitivity variations across the FOV. In energy filtering mode it may change the filtering threshold across the FOV. To avoid these effects, a de-scanning (anti scan, counter scan) signal needs to be applied to the SE bundle by the SE optics according to embodiments described herein, where three deflectors are provided for improved SE signal capturing.

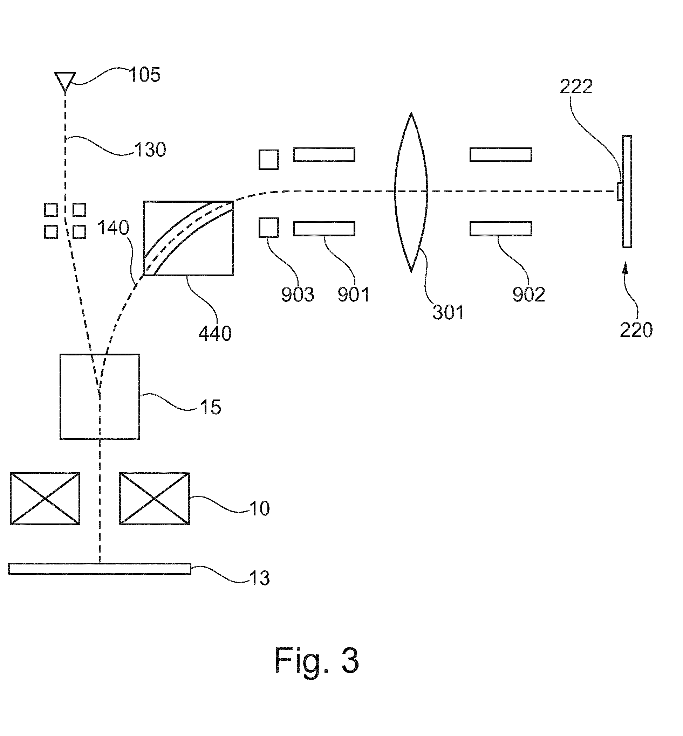

According to typical embodiments, which can be combined with other embodiments described herein, the counter scan is provided before the SE bundle enters the SE focus lens and/or a potentially existing filtering device. Thus, as shown in FIG 3 two deflectors are provided before the lens in order to allow for alignment onto the axis and along the axis of the SE optics before entering the focus lens 301. Without the embodiments described herein, focusing and angular / energy resolution will depend on the PE beam position in the FOV.

According to an embodiment, the focusing lens is an einzel-lens. According to an embodiment the focusing lens is in a deceleration mode, to keep a necessary focusing voltage low. According to yet further embodiments, which can be combined with other embodiments, described herein the focus lens 301 is closer to the sensor as compared to known SE optics, thus acting as a transfer lens of magnification ∼ 1. This avoids introducing additional magnification and unnecessary amplification of the unwanted movement of the SE bundle during scan can be reduced. Further, shifting the focus lens closer to the sensor will also reduce the necessary focus voltage.

According to an embodiment, the beam bender 440 is a hemispherical beam bender. The beam bender includes two approximately spherical and approximately concentric electrodes creating a large angle deflection field with approximately stigmatic focusing, if properly excited by two voltages (Vbend pos and Vbend neg). The deviation from the spherical shape and the relative position of the electrodes can be designed such that no hexapole component is created.

According to an embodiment, the beam bender voltages are set such that the required total deflection angle, e.g. 90°, is reached and the focusing is approximately stigmatic. The hemispherical beam bender typically focuses the first SE crossover above the objective lens stigmatically into a second crossover in front of the SE focus lens. This is a rough alignment onto the optical axis of the SE focus lens after the secondary beam exits the beam bender. However, without the third deflector 903, which is the first deflector through which the SEs pass, this can only be provided for a specific choice of the bending voltages Vbend pos and Vbend neg, which might conflict with other requirements, e.g. stigmation. Accordingly, the hemispherical sector generally does not have an independent stigmation control, unless provided with the SE optics according to any of the embodiments described herein. The same reasoning applies for the following consideration, wherein the hemispherical beam bender should typically be provided to align the optical axis of the SE bundle to the optical axis of the SE optics for any arbitrary choice of landing energy Epe of the primary electron beam.

However, without the third deflector 903, which is the first deflector through which the SEs pass, this might not be independently provided as the variations in Epe cause variations in the energy of the collected SE which result in variations of the beam splitting angle inside the beam splitter. As a consequence, this can only be adjusted by the beam bender to the center of the SE focus lens in the up-down direction in FIG. 2, but without defector 903 there are no means to align to the lens center in a direction perpendicular to the drawing plane of fig. 2. Thereby, it should be considered that even though the first deflector, the second defector and the third deflector as illustrated in the figures shown here, is only provided in one direction, the deflectors can provide at least dipole deflection fields in two directions, e.g. one in the paper plane of the figures and one orthogonal to the paper plane in the figures. Accordingly, according to the embodiments described herein, the deflectors provide at least two-dimensional deflection. In light of the above, without deflector 903, the optical axis will generally be off-center in 1 direction and tilted in both directions. As a consequence, optical quality of the imaging will be not as good as possible. Accordingly, a common SE optics does not provide independent alignment to the SE focus lens in two orthogonal directions unless provided with the SE optics according to any of the embodiments described herein

According to an embodiment, the third deflector 903 is adapted to generate orthogonal deflection fields with the ability to add a counter scan signal. The first deflector 901 is adapted to generate orthogonal dipole deflection fields. The generation of higher order multipoles in this element might not be highly effective, since a SE-crossover is formed near the element. However, it could also have a larger number of poles, e.g. 8, because a potential correction can be conducted before the SE beams enters the focusing lens. According to an embodiment, the second deflector 902, i.e. the deflector provided between lens 901 and detector 222, generates orthogonal dipole fields for alignment purposes, but can also produce a hexapole component if the hexapole of the beam bender is suppressed insufficiently or, deliberately, not at all. It is advantageous to choose, according to some embodiments, the deflector provided between the lens and the detector as an octopole element and the orientation of the deflector provided between the lens and the detector such that the upper and lower poles of the octopole are arranged self-symmetric with respect to the drawing plane of Fig. 2 (i.e. the upper pole and the lower pole of the octopole are mapped onto themselves when mirrored at the drawing plane). This yields a more obvious relation between the quadrupole and hexapole components necessary to correct for the aberrations of the beam bender, although it is not absolutely necessary since the octopole always allows rotating the fields to an arbitrary azimuthal orientation. The control electronics is adapted to provide orthogonal deflection fields, orthogonal quadrupole stigmation fields, orthogonal hexapole correction fields and a common bias for fine focusing to the 8 poles. A counter scan signal can be added.

In the embodiments illustrated in Fig. 3, a first deflector 901 is arranged between the beam bender 440 and the focusing lens 301, a second deflector 902 is provided between the focusing lens 301 and the detection element 222, and a third deflector 903, which is the first deflector, through which the SEs pass, is provided between the beam bender 440 and the focusing lens 301.

According to an embodiment, a secondary charged particle detection system for a charged particle beam device is provided. The detection system includes a beam splitter for separating a primary beam and a secondary beam formed upon impact on a specimen; a beam bender for deflecting the secondary beam; a focusing lens for focusing the secondary beam; a detection element for detecting the secondary beam particles, and three deflection elements, wherein at least a first deflector is provided between the beam bender and the focusing lens, at least a second deflector is provided between the focusing lens and the detection element, and at least a third deflector is provided between the focusing lens and the detection element.

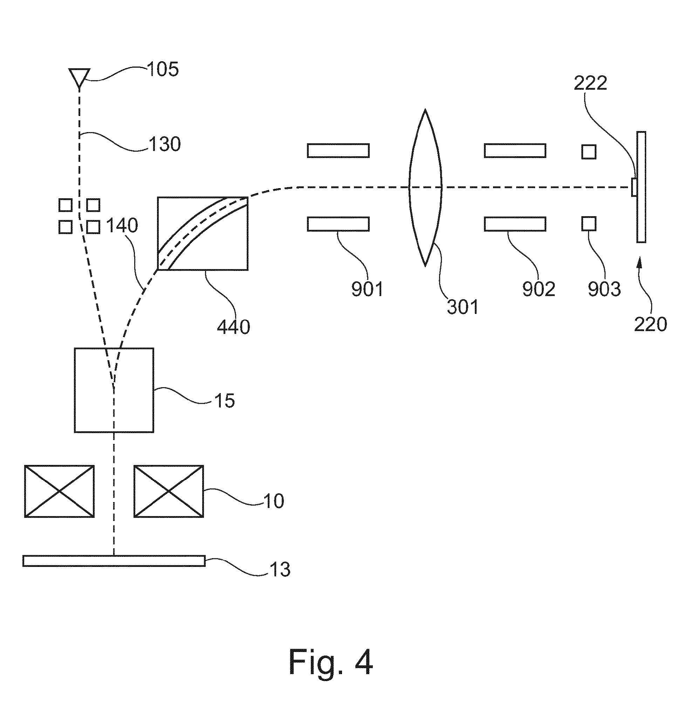

In the embodiment of Fig. 4 a first deflector 901 is arranged between the beam bender 440 and the focusing lens 301, a second deflector 902 is provided between the focusing lens 301 and the detection element 222, and a third deflector 903 is provided between the focusing lens 301 and the detection element 222.

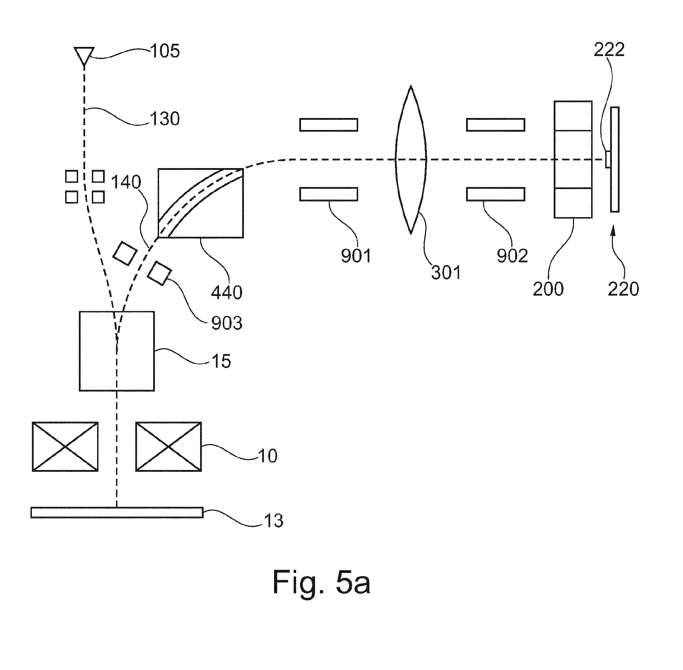

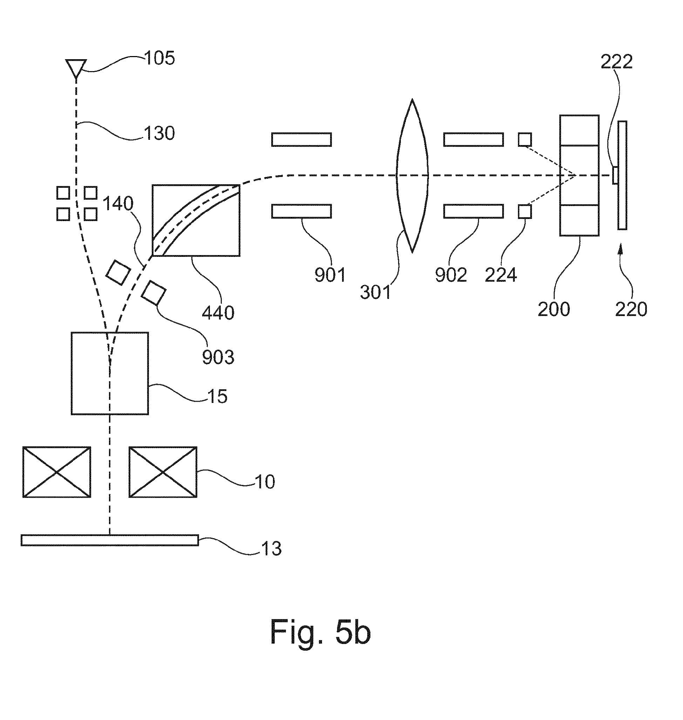

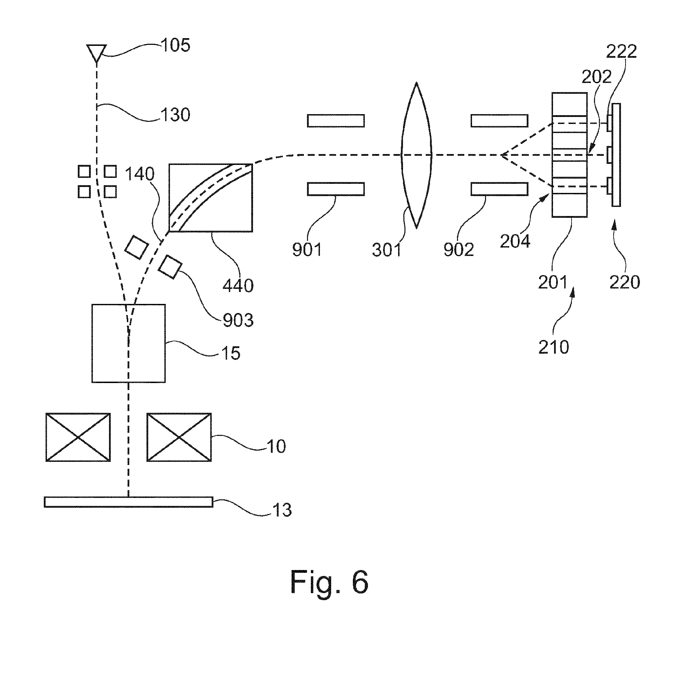

The arrangements of the third deflector 903 in the embodiments of Fig 3 and Fig. 4 (i.e. between the beam bender 440 and the focusing lens 301 in Fig. 3, and between the focusing lens 301 and the detection element 222 in Fig. 4) has the advantage that potential space restriction for a third deflector when positioned between the beam splitter and the beam bender (insufficient separation between SE and PE beam) are not as critical as compared to the embodiments described with respect to FIG. 2 and the embodiments described with respect to FIGS. 5A, 5B and 6 below. However, the third deflector still improves alignment and/or imaging of the SE signal beam on the sensor assembly having one or more sensor elements. Accordingly, signal generation and, thus, contrast can be improved. This results, as described above, in better throughput, particularly for EBI applications.

In the following reference is made to embodiments shown in FIG. 2 and FIGS. 5A, 5B and 6 and further to methods of operating thereof. According to embodiments, a coarse alignment of the optical axis after it exits the beam splitter onto the sensor can be provided by setting the beam bender voltages such that the required total deflection angle, e.g. 90°, is reached and the focusing is approximately stigmatic. Thereafter, there are various possibilities A to D to achieve 2-dimensional fine alignment of the optical axis: A) align to the center of the focusing lens using the first deflector 901, which is provided between the bender and the lens. Thereby, for example using focus wobble of the lens as a criterion while determining the image of the SEs can be provided. Such a procedure is comparably easy to adjust. Yet, a residual axis tilt can remain which may limit performance. B) A pivot point can be aligned at the center of the first deflector 901, which is provided between the bender and the lens, for example at least in the more critical up-down direction in FIG. 2 by using the beam bender. A subsequent centering to the focusing lens (using focus wobble) can be provided using the first deflector 901, which is provided between the bender and the lens. This is more difficult to control but removes the axis tilt in up-down direction. The third deflector 903, which is provided upstream of the bender or at least upstream of the deflector 901, can be used to establish the above mentioned pivot point also in the orthogonal direction, and the axis tilt can be completely compensated. In this ideal case the SE bundle axis can be made to coincide with the optical axis of the focusing lens. D) A fine alignment of the bundle to the sensor can be provided by the second deflector.

According to yet further embodiments, which can be combined with other embodiments described herein, there are various ways A to C to de-scan the secondary beam bundle: A) de-scanning with the third deflector 903 arranged between the beam splitter 15 and the beam bender 440 has the advantage that it can compensate deviations of the SE bundle emanating from an off-axial position with respect to the axis of an SE bundle starting in the center of the FOV. Since the SE-bundle will be closer to the axis in both beam bender and SE focus lens, the aberrations inflicted on the SE bundle will be minimized. B) De-scanning with the first deflector will usually not work, because a SE cross-over is formed in the vicinity of the deflector position. Therefore the movement of the cross-over will be imaged, probably even magnified, to the sensor. However, operating this deflector in sync with the scan could keep the bundle at the center of the lens and thus improve resolution. C) De-scanning with the second deflector is the least preferred but most realistic scenario. The image of the SE cross-over can be kept fixed on the sensor, but its shape may vary due to the differences in the optical path of the SE bundle throughout the system, depending on starting position inside the FOV.

According to an embodiment, focusing (or, if required, defocusing to a specified condition, e.g. for angular filtering) of the SE is achieved by the correct combination of the beam bender setting and the focusing lens excitation.

Correction of axial astigmatism can be conducted for 2 orthogonal directions, since the beam bender setting influences only the one component of the astigmatism that relates to the symmetry of the beam bender. The second, orthogonal stigmator (quadrupole) component can be excited in an additional correction element. In multi column systems where the beam bender is set to an average value and thus the astigmatism of the beam bender is not fully corrected, an independent 2-dimensional stigmator can be provided, e.g. by an octopole element or as a set of two quadrupoles which are rotated by 45° with respect to each other.

In principle the first and the second deflectors could be used, if the second deflector were rotated by 45° with respect to the first deflector. However, if the SE cross-over is approximately inside the first deflector, its quadrupole component will have no impact on the beam. Therefore, designing the second deflector as an octopole allows to generate the necessary stigmator field.

Fine focus control can be provided in multi column systems where the beam bender and SE focus are set to an average value and thus focus is not fully corrected for all columns simultaneously. Fine focus can be achieved by biasing the deflectors with a constant voltage, preferably the second octopole deflector which would yield the most uniform effect as compared to the other deflectors.

Correction of the beam bender hexapole can be important for undisturbed angular filtering. It can be achieved by the following means (or a combination thereof): A) Modifying the spherical shape and the relative position of the electrodes of the deflectors, in the event electrostatic deflectors are used, can be used to cancel the hexapole field that accompanies the deflection field. B) A compensating hexapole can be excited inside a suitable element, e.g. the octopole of the second deflector. C) According to yet further additional or alternative modifications, since the orientation of the hexapole is known, it would be sufficient to have a single 6-pole element with the appropriate orientation for correction of the hexapole.

According to an embodiment, a secondary charged particle detection system for a charged particle beam device is provided. The detection system includes a beam splitter for separating a primary beam and a secondary beam formed upon impact on a specimen; a beam bender for deflecting the secondary beam; a focusing lens for focusing the secondary beam; a detection element for detecting the secondary beam particles, and three deflection elements, wherein at least a first deflector is provided between the beam bender and the focusing lens, at least a second deflector is provided between the focusing lens and the detection element, at least a third deflector is provided between the beam bender and the focusing lens.

According to an embodiment, a secondary charged particle detection system for a charged particle beam device, described in the embodiments further includes an energy filtering electrode.

According to a further embodiment, an energy filtering electrode is provided between the focusing lens and the detection element.

Fig. 5a shows an embodiment of a secondary charged particle detection system for a charged particle beam device including an energy filtering electrode 200 (or a retarding electrode), arranged between the focusing lens 301 and the detection element 222. According to an embodiment, the energy filtering electrode 200 allows energy filtering of the secondary particle bundle. According to yet further embodiment, which can be combined with other embodiments described herein, the energy filtering electrode can be a tube or a plate that can be biased to a voltage close to the voltage applied to the specimen.

The electron beam enters filter 200 provided in form of a cylinder. Within the cylinder a potential-saddle is applied due to biasing of the cylinder. Electrons having a sufficiently large energy can pass the potential-saddle (potential hill). Other electrons are backwardly redirected. Yet, all electrons are influenced by the same potential-saddle. In order to have all electrons being influenced by the same saddle potential, the opening of the cylinder requires a defined sufficiently large size. Thereby, the transparency of the filter is increased. There are no losses due to impingement of electrons on a grid and hardly any losses due to an insufficiently focused beam.

According to an embodiment, additional detection elements 224 or sensors can be arranged around an optical axis in the detection system as shown in Fig. 5b.

Thereby, the energy filtering detector can include the following features: a divider is provided, e.g. in the form of a filter 200 as described above, to divide the beam of charged particles according to their energies into a low energy beam and a high energy beam. A front detector 222 for detecting the high energy beam; and at least one reverse detector 224 for detecting the low energy beam, wherein the divider is positioned between the at least one reverse detector and the front detector is provided. The at least one reverse detector and/or the front detector is segmented to provide a spatial resolution of the particles from the incoming beam of charged particles.

According to an embodiment, a secondary charged particle detection system for a charged particle beam device, described in the embodiments further includes a topography detector. According to a further embodiment, a topography detector is provided between the focusing lens and the detection element.

Fig. 6 shows an embodiment of a secondary charged particle detection system for a charged particle beam device including a topography detector 210 with a plate 201, arranged between the focusing lens 301 and the detection element 222. Thereby, e.g. topographic information of the inspected feature can be used to further increase the contrast. Topography detectors are usually divided into 4 or more segments (with or without a central BF area) which can be read separately. The signals can then be combined (e.g. subtracted) to enhance contrast.

For multi perspective imaging, including energy or angular filtering, the information carried by the SE needs to be conserved while the beam is transferred from the sample to the sensor. In a EBI system with an SE optics according to embodiments described herein, this is provided by an optical system including a beam splitter 15 that separates the primary beam 130 and the SE bundle 140, a beam bender 440 that deflects the SE bundle to a large angle (typically 90° for horizontal exit), SE focus lens 301 and a first, a second and a third alignment deflector for focusing and aligning the beam to the sensor.

According to an embodiment the topography detector 210 allows topographic imaging using multiple separated sensor channels, but can also be switched to BF imaging and energy filtering mode.

According to an embodiment, a charged particle beam device is provided, including a secondary charged particle detection system. The detection system includes a beam splitter for separating a primary beam and a secondary beam formed upon impact on a specimen; a beam bender for deflecting the secondary beam; a focusing lens for focusing the secondary beam; a detection element for detecting the secondary beam particles, and three deflection elements, wherein at least a first deflector is provided between the beam bender and the focusing lens, at least a second deflector is provided between the focusing lens and the detection element, at least a third deflector is provided between the beam splitter and the detection element.

According to one embodiment, a secondary charged particle detection device for detection of a signal beam is provided, wherein the detection device can be part of an SE optics according to embodiments described herein. The device includes a detector arrangement having at least two detection elements with active detection areas, wherein the active detection areas are separated by a gap, a particle optics configured for separating the signal beam into a first portion of the signal beam and into at least one second portion of the signal beam, and configured for focusing the first portion of the signal beam and the at least one second portion of the signal beam. The particle optics includes an aperture plate and at least a first aperture opening in the aperture plate, and at least one second aperture opening in the aperture plate, wherein the aperture plate is configured to be biased to one potential surrounding the first aperture opening and the at least one second aperture opening.

According to embodiments described herein, the SE particle optics includes at least an aperture plate 201 having two or more aperture openings. The aperture plate 201 can be biased to a deceleration potential. Thereby, the deceleration of the aperture plate 201 in combination with an acceleration of the detection elements 222 are configured for a separation and focusing of the secondary particles, e.g. the secondary electron beam. In light of the two or more aperture openings, the separation of the secondary beam on different detection elements can be provided. According to typical embodiments, the aperture plate 201 has a central aperture opening 202 and at least two radially outer aperture openings 204. Typically, four outer aperture openings 204 can be provided.

According to another embodiment, a method of detection of secondary charged particles in a charged particle beam device is provided. The method includes separating a secondary beam from a primary beam by means of a beam separator; deflecting the separated secondary beam by means of a main deflector; and focusing the secondary beam on a detection element by means of a focusing lens; wherein the secondary beam is deflected by at least a first deflector provided between the beam bender and the focusing lens, at least a second deflector provided between the focusing lens and the detection element, and at least a third deflector provided between the beam splitter and the detection element.

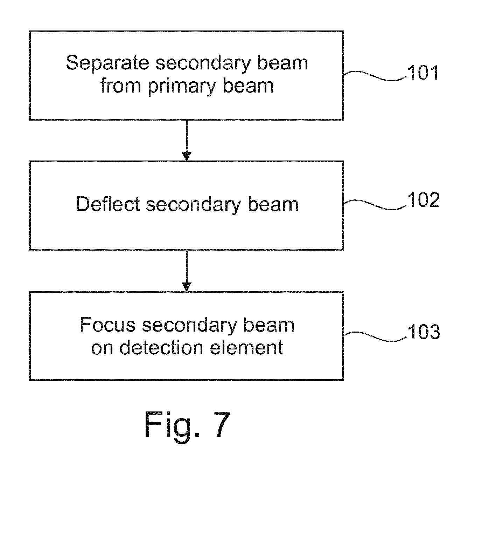

Fig. 7 shows a block diagram of a method of detection of charged particles in a charged particle beam device according to embodiments described herein. The method includes: separating 101 a secondary beam from a primary beam by means of a beam separator; deflecting 102 the separated secondary beam by means of a main deflector; focusing 103 the secondary beam on a detection element by means of a focusing lens; wherein the focusing of the secondary beam is conducted such that a minimum aberration plane within the main deflector is imaged onto the detection element.

While the foregoing is directed to embodiments of the invention, other and further embodiments of the invention may be devised without departing from the basic scope thereof, and the scope thereof is determined by the claims that follow.

## Claims

1. A secondary charged particle detection system for a charged particle beam device, the detection system comprising:
a beam splitter (15) for separating a primary beam (130) and a secondary beam (140) formed upon impact on a specimen (13),
a beam bender (440) for deflecting the secondary beam,
a focusing lens (301) for focusing the secondary beam,
a detection element (222) for detecting the secondary beam particles, and
three deflection elements,
wherein at least a first deflector (901) is provided between the beam bender (440) and the focusing lens (301),
at least a second deflector (902) is provided between the focusing lens (301) and the detection element (222),
at least a third deflector (903) is provided between the beam splitter (15) and the detection element (222).

2. Secondary charged particle detection system according to claim 1,
wherein at least a third deflector (903) is provided between the beam splitter (15) and the beam bender (440).

3. Secondary charged particle detection system according to claim 1,
wherein at least a third deflector (903) is provided between the beam bender (440) and the focusing lens (301).

4. Secondary charged particle detection system according to claim 1,
wherein at least a third deflector (903) is provided between the focusing lens (301) and the detection element (222).

5. Secondary charged particle detection system according to any of claims 1 to 4, further comprising an energy filtering electrode (200).

6. Secondary charged particle detection system according to claim 5,
wherein the energy filtering electrode (200) is provided between the focusing lens (301) and the detection element (222).

7. Secondary charged particle detection system according to any of claims 1 to 4, further comprising a topography detector (210).

8. Secondary charged particle detection system according to claim 7,
wherein the topography detector (210) is provided between the focusing lens (301) and the detection element (222).

9. A charged particle beam device, comprising a secondary charged particle detection system according to any of the preceding claims.

10. A method of detection of secondary charged particles in a charged particle beam device, the method comprising:
separating a secondary beam (140) from a primary beam (130) by means of a beam separator;
deflecting the separated secondary beam (140) by means of a main deflector (440); and
focusing the secondary beam (140) on a detection element (222) by means of a focusing lens (301);
wherein the secondary beam is deflected by
at least a first deflector (901) provided between the beam bender (15) and the focusing lens (301),
at least a second deflector provided (902) between the focusing lens (301) and the detection element (222), and
at least a third deflector (903) provided between the beam splitter (15) and the detection element (222).

11. Method according to claim 10, wherein at least a third deflector (903) is provided between the beam splitter (15) and the beam bender (440).

12. Method according to claim 10, wherein at least a third deflector (903) is provided between the beam bender (440) and the focusing lens (301).

13. Method according to claim 10, wherein at least a third deflector (903) is provided between the focusing lens (301) and the detection element (222).

14. Method according to any of claims 10 to 13, further comprising energy filtering of the secondary beam by means of an energy filtering electrode (200).

15. Method according to any of claims 10 to 13, further comprising topography detection of the secondary beam by means of a topography detector (210).
